# EUROPEAN PATENT APPLICATION

(11) **EP 3 901 571 A1**
(43) Date of publication of application: **27.10.2021**
(21) Application number: 20315204.6
(22) Date of filing: 21.04.2020
(51) Int. Cl.: G01B 11/24, G01B 11/30, G01N 21/952, G06T 7/00, G06T 7/30, G06T 7/50, G01R 31/12

(54) **SURFACE QUALITY DETERMINATION OF A HIGH VOLTAGE CABLE END**

(71) Applicant: Nexans, 92400 Courbevoie (FR)
(72) Inventor: Doedens, Espen, 43138 Mölndal (SE)
(74) Representative: Ipsilon

(57) **Abstract**

The invention relates to a system and a method for determining a quality of a surface of a high voltage cable end. The method comprising moving a non-contact surface scanner about the cable end, measuring distance to the surface over the area of the surface by sequentially measuring a plurality of sub-areas of the area of the surface, creating a continuous 3D surface geometry measurement of the surface of the cable end and comparing, using the continuous 3D surface geometry measurement with at least one surface geometry acceptance threshold determining the quality of the surface of the high voltage cable end.

## Description

### Technical field

The present invention relates to high voltage cable ends, in particular for a system and method of determining a quality of a surface of the high voltage cable end.

### Background

A high voltage (HV) cable is used for electric power transmission at high voltage, e.g. above 1 000 V. A HV-cable includes a conductor and an insulation. The insulation may consist of polymers or polyethylene, including cross-linked polyethylene (XLPE). At inner and outer sides of the insulation semiconducting layers are fused to the insulation. The semiconducting layers prevent air-filled cavities between the metal conductors and the dielectric so that small electric discharges cannot arise and endanger the insulation material. The insulation is usually also covered by a copper or aluminum wire screen, or a lead or aluminium or copper jacket, or combinations thereof. This metallic screen or jacket is followed by a polymeric (e.g. PE or PVC) outer sheath.

The HV-cables are manufactured in cable manufacturing lines using extrusion. The quality control and meeting product specifications are very important in HV-cable production. A failure due to dielectric breakdown in the HV-cable may cause a break to power supply. For instance, high voltage cables are used for long length connections for power distribution and power transmission. The manufacturing quality is monitored during the operation of the cable manufacturing line to assure the quality of the final product.

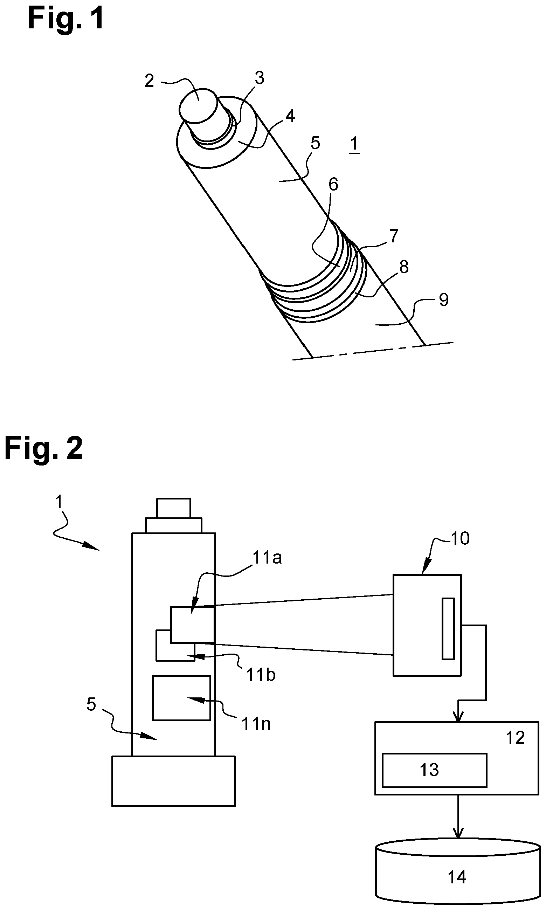

For HV cable accessory installations, such as cable joints and terminals, the outer layers are removed from an end of the HV-cable, by cutting, sanding or any other method by an operator, to make a HV-cable end 1. Fig. 1 show an exemplary HV-cable end 1. The outer sheath 9, the lead sheath 8, swelling tapes 7 and the outer semiconducting screen 6 have been removed, leaving the conductor 2, the inner semiconducting screen 3 and the insulation 4. The surface 5 of the insulation 4 is inspected to ensure that there are no irregularities, before a HV cable accessory, such as a rubber joint, is slipped over it. The surface 5 of the insulation 4 is subjected to tangential and radial fields where it sits between the cable and the HV accessory component, it is therefore crucial to determine the quality of the surface 5 of the insulation 4.

The cable joint/termination is made on-site in a hall or a bunker through manual skilled labor. The determination of the quality of the surface 5 of the insulation 4 has to be done on-site in the bunker where the joint is made, for each of hundreds of joints a project typically involves. Today, the inspection and determination of the quality of the surface 5 is carried out with human eye by an operator in the bunker, and there is always a certain risk that defects may be missed by the operator in the manual determination. In addition, human eye inspection provides limited data for future quality revisions and fault findings.

WO2019197530A1 discloses a device for continuous monitoring of the quality of the extruded surface, i.e. capable of monitoring the surface of the HV-cable for defects and detect the defects automatically. It is arranged to be positioned in-line an HV-cable extrusion. The device comprises a plurality of non-contact distance measurement sensor arranged around the cable, e.g. the cable passes between the sensors in the production line, such that the measurement area of each of the sensor in total covers the circumference of the cable for a given length of the cable in the run direction of the cable. An analysis parts processes the measurement data to provide defect detection data and a continuous 3D topographic map of the outer surface of the cable, and detects surface defects of the cable and outputs surface defects detection data. The disclosed system is large and not suitable for use in on-site bunkers for making of cable joint/terminations. Furthermore, the disclosed system requires that the cable ends are put into the scanner, or the scanner is slid over the cable ends, which would be very difficult for such a large scanner device as well as the size the of the HV-cables.

In view of the above, the aim of the present invention is to provide method for determining the quality of a surface of a high voltage cable end, and system of determining the quality of the surface of the high voltage cable end, that solves or at least mitigate one or more of the above-mentioned problems related to the inspection of the quality of the surface of a high voltage cable end..

### Summary of the invention

In one aspect of the present invention it is provided a method for determining a quality of a surface of a high voltage cable end, the method comprising providing a high voltage cable end, wherein at least one outer layer of a high voltage cable has been removed, thereby exposing a surface of the high voltage cable end, moving a non-contact surface scanner about the cable end such that the non-contact surface scanner measures distance to the surface over the area of the surface by sequentially measuring a plurality of sub-areas of the area of the surface, creating a continuous 3D surface geometry measurement of the surface of the cable end by processing measurement data from the non-contact surface scanner for each of the plurality of sub-areas, and comparing, using a processor, the continuous 3D surface geometry measurement with at least one surface geometry acceptance threshold determining the quality of the surface of the high voltage cable end

In some embodiments of the method, the at least one surface geometry acceptance threshold may be a go/no go test criteria.

In some embodiments of the method, the at least one surface geometry acceptance threshold may be a height variation threshold.

In some embodiments of the method, the at least one surface geometry acceptance threshold may be surface derivative threshold.

In some embodiments of the method, the at least one surface geometry acceptance threshold may be a peeling wave threshold.

In some embodiments of the method, the at least one surface geometry acceptance threshold may be at least one of an area of a cut, a depth of a cut, and a slope of a cut.

In some embodiments of the method, the method may further comprise transmitting the continuous 3D surface geometry measurement to a storage device as a 3D topographic map of the surface of the cable end.

In some embodiment of the method, the non-contact surface scanner may be a 3D laser scanner.

In some embodiments of the method, the 3D laser scanner may be a handheld 3D laser scanner.

In a second aspect the invention it is provided a system for scanning a surface of a high voltage cable end, the system comprising a non-contact surface scanner, the non-contact surface scanner being directable to a sub-area on a surface of the cable end, the non-contact surface scanner being arranged to be movable about the cable end to measure distance to the surface over the area of the surface by sequentially measuring a plurality of sub-areas of the area of the surface, and an analysis part comprising a processor adapted to process measurement data from the non-contact surface scanner for each of the plurality of sub-areas to create a continuous 3D surface geometry measurement of the surface of the cable end, and comparing the continuous 3D surface geometry measurement with at least one surface geometry acceptance threshold determining the quality of the surface of the high voltage cable end.

In some embodiments of the system, the at least one surface geometry acceptance threshold may be a go/no go test criteria.

In some embodiments of the system, the at least one surface geometry acceptance threshold may be a height variation threshold.

In some embodiments of the system, the at least one surface geometry acceptance threshold may be a surface derivative threshold.

In some embodiments of the system, the at least one surface geometry acceptance threshold may be a peeling wave threshold.

In some embodiments of the system, the at least one surface geometry acceptance threshold may be at least one of an area of a cut, a depth of a cut, and a slope of a cut.

In some embodiments of the system, the analysis part may be adapted to transmit the continuous 3D surface geometry measurement to a storage device as a 3D topographic map of the surface of the cable end.

In some embodiments of the system, the non-contact distance measurement sensor may be a 3D laser scanner.

In some embodiments of the system, the 3D laser scanner may be a handheld 3D laser scanner.

### Brief Description of the drawings

Following drawings are appended to facilitate the understanding of the invention. The drawings show embodiments of the invention, which will now be described by way of example only, where:
- Fig. 1: is a perspective view of a high voltage cable end.
- Fig. 2: is a schematic illustration of a system according to the present invention.
- Fig. 3: a flow chart of an exemplary method according to the invention.
- Fig. 4: shows an exemplary continuous 3D surface geometry measurement of a surface of a cable according to the present invention.
- Fig. 5: shows a detail of the exemplary continuous 3D surface geometry measurement of Fig. 4.

### Detailed description of the invention

In the following, different alternatives will be discussed in more detail with reference to the appended drawings. It should be understood, however, that the drawings are not intended to limit the scope of the invention to the subject-matter depicted in the drawings. The scope of the invention is defined in the appended claims.

In the exemplary embodiments, various features and details are shown in combination. The fact that several features are described with reference to a particular example should not be construed as implying that those features be necessity have to be included together in all the embodiments of the invention. Conversely, features that are described with reference to different embodiments should not be construed as mutually exclusive. As those skilled in the art will readily understand, embodiments that incorporate any subset of features described herein and that are not expressly interdependent have been contemplated by the inventor and are part of the intended disclosure. However, explicit descriptions of all such embodiments would not contribute to the understanding of the principles of the invention, and consequently some permutations have been omitted for the sake of simplicity.

Fig. 2 is a schematic illustration of a system according to the present invention for scanning the surface 5 of a high voltage cable end 1. The sizes of various object of the illustration are not in scale. The system comprises a non-contact surface scanner 10. The non-contact surface scanner 10 is directable to a sub-area 11a, 11b, ..., 11n of the surface 5 of the cable end 1. The sub-area 11a, 11b, ..., 11n on the surface 5 may be defined by the field-of-view or scanning area of the non-contact surface scanner 10. In one embodiment, the non-contact surface scanner 10 may be a 3D laser scanner. The sub-area 11a, 11b, ..., 11n may be round, rectangular, linear or any other shape as determined by the non-contact surface scanner. The non-contact surface scanner 10 is arranged to measure the distance to the surface 5 of the sub-area 11a, 11b, ..., 11n. The non-contact surface scanner 10 is movable around the cable end 1 such that the surface 5 of the cable end 1 is covered by a plurality of sub-areas 11a, 11b, ..., 11n. The size of plurality of sub-areas 11a, 11b, ..., 11n may vary, for example by varying the distance between the non-contact surface scanner 10 and the cable end 1. In one embodiment the non-contact surface scanner 10 is freely movable in any direction around the cable end 1, such as a handheld 3D laser scanner. The non-contact surface scanner 10 knows its position and direction in 3D space my recognizing a plurality of markers (not shown) positioned on the surface 5. The markers may be stickers or sterile clamps with specific patterns or markers thereon. The markers will result in "NaN" (not a number = empty) areas underneath them, however, the scan can be paused, markers/clamps relocated and then the measurement can also scan the area under the markers. In another embodiment the non-contact surface scanner 10 may be mounted to a jig, e.g. mountable to the HV-cable, such that the non-contact surface scanner 10 may be moved up/down and around the surface 5 to completely fill the surface 5 with sub-areas 11a, 11b, ..., 11n. In this way, using markers may be avoided.

The illustrated system 2 also comprises an analysis part 12. The analysis part 12 is in communication with the non-contact surface scanner 10 over a wired or wireless communication link. In one embodiment, at least parts of the analysis part 12 may be comprised in the non-contact surface scanner 10. The analysis part 12 comprises a processor 13 adapted to process measurement data from the non-contact surface scanner 10 for each of the plurality of sub-areas 11a, 11b, ..., 11n to create a continuous 3D surface geometry measurement of the surface 5 of the cable end 1, and comparing the continuous 3D surface geometry measurement with at least one surface geometry acceptance threshold determining the quality of the surface 5 of the high voltage cable end 2.

In one embodiment, the at least one surface geometry acceptance threshold is a go/no go test criteria. In this way an operator may receive a go or a no go after the scan is performed, allowing or disallowing the operator proceed mount a HV cable accessory, such as a rubber joint. The at least one surface geometry acceptance threshold may be based on at least one of a height variation threshold, a surface derivative threshold, a peeling wave threshold and/or at least one of an area of a cut, a depth of a cut, and a slope of a cut.

In one embodiment, the analysis part 12 is adapted to transmit the continuous 3D surface geometry measurement to a storage device 14 as a 3D topographic map of the surface 5 of the cable end 1. The analysis part 12 is in communication with the storage device 14 over a wired or wireless communication link. The storage device 14 may be on on-premise server or cloud server. The 3D topographic map of the surface 5 of the cable end 1 on the server 14 may be accessible to users and clients for future reference of the cable system.

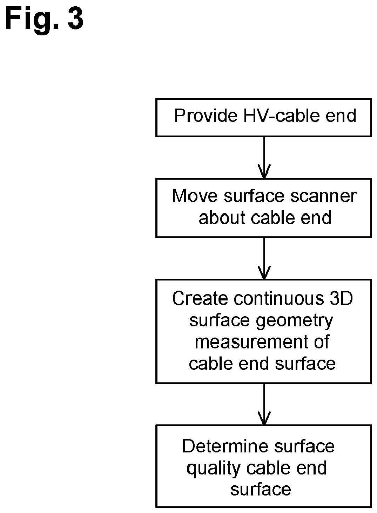

Now with additional reference to Fig. 3. Fig. 3 is a flowchart illustrating an exemplary method for determining the quality of a surface of a high voltage cable end according to the present invention. First a high voltage cable end 1 is provided, where at last one outer layer of a high voltage cable has been removed, thereby exposing a surface 5 of the high voltage cable end 1. The at last one outer layer of a high voltage cable may have been removed by cutting, sanding or any other method by an operator skilled in the art. Then, the non-contact surface scanner 10 is moved about the cable end 1 such that the non-contact surface scanner 10 measures distance to the surface 5 over the area of the surface 5 by sequentially measuring a plurality of sub-areas 11a, 11b, ..., 11n of the area of the surface 5. Then a continuous 3D surface geometry measurement of the surface 5 of the cable end 1 is created by processing measurement data from the non-contact surface scanner 10 for each of the plurality of sub-areas 11a, 11b, ..., 11n. Finally, the continuous 3D surface geometry measurement is compared, using the processor 13, measurement with at least one surface geometry acceptance threshold determining the quality of the surface 5 of the high voltage cable end 1.

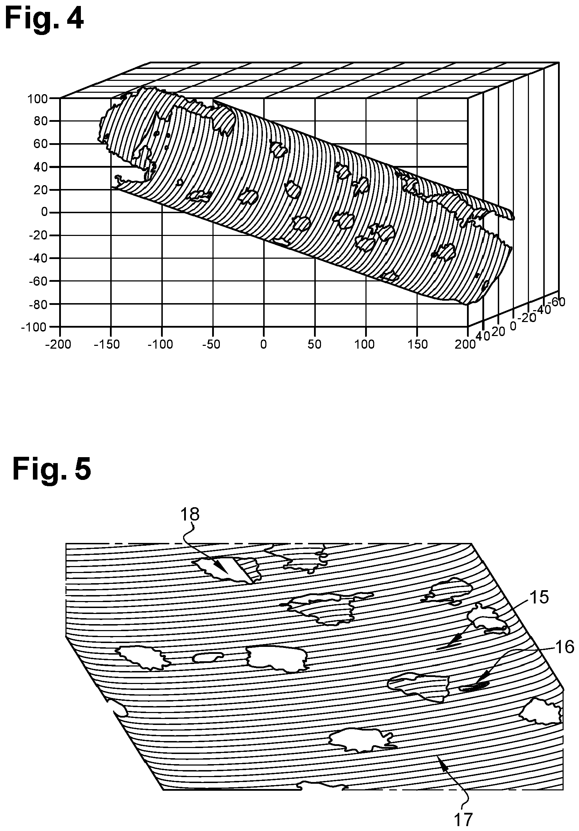

Figs. 4 and 5 show an exemplary continuous 3D surface geometry measurement of a surface of a cable end. The holes 18 in the continuous 3D surface geometry measurement indicates the marker positions. Fig. 5 shows details of Fig. 4 indicating observed defects on the surface of the cable end, such as a large shallow cut 15, a large deeper 16, and a narrow cut 17. Figs. 4 and 5 show the continuous 3D surface geometry measurement in greyscale. The continuous 3D surface geometry measurement may advantageously be shown in various colourmaps to improve visibility of detected defects, e.g. highlighting surface derivatives.

## Claims

1. A method for determining a quality of a surface of a high voltage cable end, the method comprising
providing a high voltage cable end (1), wherein at least one outer layer of a high voltage cable has been removed, thereby exposing a surface (5) of the high voltage cable end (1);
moving a non-contact surface scanner (10) about the cable end (1), such that the non-contact surface scanner (10) measures distance to the surface (5) over the area of the surface (5) by sequentially measuring a plurality of sub-areas (11a, 11b, ..., 11n) of the area of the surface (5);
creating a continuous 3D surface geometry measurement of the surface (5) of the cable end (1) by processing measurement data from the non-contact surface scanner (10) for each of the plurality of sub-areas (11a, 11b, ..., 11n);
comparing, using a processor (13), the continuous 3D surface geometry measurement with at least one surface geometry acceptance threshold determining the quality of the surface (5) of the high voltage cable end (1).

2. The method of claim 1, wherein the at least one surface geometry acceptance threshold is a go/no go test criteria.

3. The method of any of the preceding claims, wherein the at least one surface geometry acceptance threshold is a height variation threshold.

4. The method of any of the preceding claims, wherein the at least one surface geometry acceptance threshold is a surface derivative threshold.

5. The method of any of the preceding claims, wherein the at least one surface geometry acceptance threshold is a peeling wave threshold.

6. The method of any of the preceding claims, wherein the at least one surface geometry acceptance threshold is at least one of an area of a cut, a depth of a cut, and a slope of a cut.

7. The method of any of the preceding claims, further comprising transmitting the continuous 3D surface geometry measurement to a storage device (14) as a 3D topographic map of the surface (5) of the cable end (1).

8. A system for scanning a surface of a high voltage cable end, the system comprising
a non-contact surface scanner (10), the non-contact surface scanner (10) being directable to a surface (5) of the cable end (1), the non-contact surface scanner (10) being arranged to be movable about the cable end (1) to measure distance to the surface (5) over the area of the surface (5) by sequentially measuring a plurality of sub-areas (11a, 11b, ..., 11n) of the area of the surface (5); and
an analysis part (12) comprising a processor (13) adapted to process measurement data from the non-contact surface scanner (10) for each of the plurality of sub-areas (11a, 11b, ..., 11n) to create a continuous 3D surface geometry measurement of the surface (5) of the cable end (1), and comparing the continuous 3D surface geometry measurement with at least one surface geometry acceptance threshold determining the quality of the surface (5) of the high voltage cable end (2).

9. The system according to claim 8, wherein the at least one surface geometry acceptance threshold is a go/no go test criteria.

10. The system of any of claims 8 - 9, wherein the at least one surface geometry acceptance threshold is a height variation threshold.

11. The system of any of claims 8 - 10, wherein the at least one surface geometry acceptance threshold is a surface derivative threshold.

12. The system of any of claims 8 - 11, wherein the at least one surface geometry acceptance threshold is a peeling wave threshold.

13. The system of any of claims 8 - 12, wherein the at least one surface geometry acceptance threshold is at least one of an area of a cut, a depth of a cut, and a slope of a cut.

14. The system of any of claims 8 - 13, wherein the analysis part (12) is adapted to transmit the continuous 3D surface geometry measurement to a storage device (14) as a 3D topographic map of the surface (5) of the cable end (1).

15. The system of any of claims 8 - 14, wherein the non-contact distance measurement sensor (10) is a 3D laser scanner.

16. The system according to claim 15, wherein the 3D laser scanner (10) is a handheld 3D laser scanner.
